# EUROPEAN PATENT APPLICATION

(11) **EP 4 239 658 A1**
(43) Date of publication of application: **06.09.2023**
(21) Application number: 22159979.8
(22) Date of filing: 03.03.2022
(51) Int. Cl.: H01L 21/20, H01L 21/322, H01L 21/265

(54) **A METHOD FOR MANUFACTURING A SUBSTRATE WAFER FOR BUILDING GROUP III-V DEVICES THEREON AND A SUBSTRATE WAFER FOR BUILDING GROUP III-V DEVICES THEREON**

(71) Applicant: Siltronic AG, 81677 München (DE)
(72) Inventor: Murphy, Brian, 84347 Pfarrkirchen (DE); Thapa, Sarad Bahadur, 84489 Burghausen (DE)
(74) Representative: Staudacher, Wolfgang

(57) **Abstract**

A method for manufacturing a substrate wafer for building group III-V devices thereon, comprising
providing a silicon single crystal wafer;
forming a gettering region below a top surface of the silicon single crystal wafer;
forming a nitrogen enriched passivation layer representing a top portion of the substrate wafer.

## Description

The invention provides a method for manufacturing a substrate wafer for building group III-V devices thereon and a substrate wafer for building group III-V devices thereon.

### Prior Art / Problems

Group III-V devices like high-electron-mobility transistors (HEMTs) are known for their superior performance in high power applications and high frequency applications. A vast amount of patent and non-patent literature dealing with this topic is available.

For example, US 2016 0 240 646 A1 discloses the structure and the fabrication of a couple of HEMT devices that may be built over a substrate wafer.

According to US 2014 0 117 502 A1, a gettering region may be provided in a semiconductor substrate wafer.

Many approaches have been pursued to mitigate leakage currents within the device structure and the provision of a passivating layer is one tool to deal with this problem.

For example, WO 2015 123 534 A1 discloses the provision of a buried implantation layer in a buffer region of the group III-V device in order to suppress a leakage current in the direction normal to the substrate.

The inventor of the present invention has found that the substrate wafer needs to be improved, in particular in order to prevent dangling bonds from raising defect state densities and charge densities disturbing the proper function of the group III-V device.

### Description

The present invention is directed to a method for manufacturing a substrate wafer for building group III-V devices thereon, comprising
providing a silicon single crystal wafer;
forming a gettering region below a top surface of the silicon single crystal wafer;
forming a nitrogen enriched passivation layer representing a top portion of the substrate wafer.

Dangling bonds are saturated or neutralized by providing at least one nitrogen enriched region that forms a nitrogen enriched passivation layer. The nitrogen enriched passivation layer does not form a separate silicon nitride layer deposited on the silicon single crystal wafer and lacks negative side effects of a separate layer. Moreover, impurities are trapped with a gettering region provided below the top surface of the silicon single crystal wafer.

The nitrogen enriched passivation layer may be formed by diffusing nitrogen or implanting nitrogen ions in a top region of the silicon single crystal wafer. The silicon single crystal wafer may be subjected to an annealing step in a nitrogen containing gas atmosphere in order to diffuse nitrogen into the top region of the silicon single crystal wafer. The annealing step may be performed as a flash lamp anneal. The nitrogen containing atmosphere may contain nitrogen or ammonia (NH₃) or a mixture thereof. The annealing temperature may be in a range of not less than 300 °C and not more than 1350 °C. Alternatively, nitrogen ions may be implanted into a region under the top surface of the silicon single crystal wafer and, optionally, subjected to a following thermal treatment. The temperature of the following thermal treatment may be in a range of not less 300 °C and not more than 1350 °C. A further alternative comprises introducing nitrogen radicals generated in a plasma to the surface of the silicon single crystal wafer. The concentration of nitrogen that is additionally present at the surface of the silicon single crystal wafer is preferably not less than 1.0 × 10¹¹ atoms/cm², but less than the quantity to form a stoichiometric silicon nitride layer on the surface of the silicon single crystal wafer. The density of silicon atoms with dangling bonds on the surface is thereby reduced to preferably less than 1 × 10¹¹ atoms/cm², more preferably less than 1 × 10¹⁰ atoms/cm² and most preferably less than 1 × 10⁹ atoms/cm².

In addition to or as an alternative, the nitrogen enriched passivation layer may be formed by depositing an AIN (aluminium nitride) nucleation layer contacting the top surface of the silicon single crystal wafer, and temporarily adding additional nitrogen during the deposition. As a result, the nitrogen concentration in the AIN nucleation layer is higher in a top region and a bottom region of the AIN nucleation layer compared to a region between the top region and the bottom region. For this purpose, the partial pressure of the nitrogen containing precursor gas may be temporarily increased during the deposition of the AIN nucleation layer. The deposition of the AIN nucleation layer may be performed as MOCVD (metal organic chemical vapor deposition), molecular ion-beam epitaxy (MBE). As precursor compounds trimethylaluminum and ammonia can be used for MOCVD. Hydrogen or nitrogen is a suitable carrier gas. The growth temperature of the AIN layer is preferably not less than 700 °C and not more than 1250 °C for MOCVD, and not less than 400 °C and not more than 900 °C for MBE. The AIN nucleation layer has a thickness which is preferably not less than 10 nm and preferably not more than 500 nm, more preferably not more than 200 nm. The nitrogen enriched passivation layer in the top region of the AIN nucleation layer is not thicker than 10 nm and most preferably not more than 5 nm.

In order to enrich the AIN nucleation layer with nitrogen, additional nitrogen precursor gas is applied during the deposition of a bottom region and a top region of the AIN nucleation layer. The partial pressure of a nitrogen containing precursor gas may be temporarily increased during the deposition of the AIN nucleation layer. The concentration of nitrogen that is present in the bottom and the top region of the AIN nucleation layer is at least 1% higher than the Al concentration and at most 50 % higher than the Al concentration in the region between the top and bottom regions.

Moreover, a gettering region is formed below a top surface of the silicon single crystal wafer. The gettering region may be formed before the nitrogen enriched passivation layer is formed. The gettering region may be formed by implanting hydrogen ions into the silicon single crystal wafer and annealing the silicon single crystal wafer to form a layer of buried voids. The gettering region may be formed after the formation of the nitrogen enriched passivation layer by implanting the hydrogen ions into the substrate wafer from its back side and annealing the substrate wafer.

Alternatively, the gettering region may be formed as an end-of-range damage (EOR) when the nitrogen ions are implanted in the top region of the silicon single crystal wafer to form the nitrogen enriched passivation layer by implanting nitrogen ions into the silicon single crystal wafer.

Furthermore, the invention is directed to a substrate wafer for building group III-V devices, comprising
a silicon single crystal wafer;
a gettering region below the top surface of the silicon single crystal wafer; and
a nitrogen enriched passivation layer.

The nitrogen enriched passivation layer may be part of the AIN nucleation layer contacting the top surface of the silicon single crystal wafer or may form a top portion of the silicon single crystal wafer.

Preferably, a concentration of nitrogen in the AIN nucleation layer is higher in a top region and a bottom region of the AIN nucleation layer compared to a region between the top region and the bottom region of the AIN nucleation layer.

The gettering region may consist of a layer of buried voids or of an end-of-range damage.

The silicon single crystal wafer may be a wafer cut from a silicon single crystal that has been grown according to the CZ-method by pulling a seed crystal from a melt contained in a crucible or FZ-method. The silicon single crystal wafer has a diameter that is at least 150 mm, preferably at least 200 mm and most preferably 300 mm. The lattice orientation of the silicon single crystal wafer may be preferably (100) or (111) or (110).

The description of the invention is continued with referral to a drawing.

### Brief description of the figure

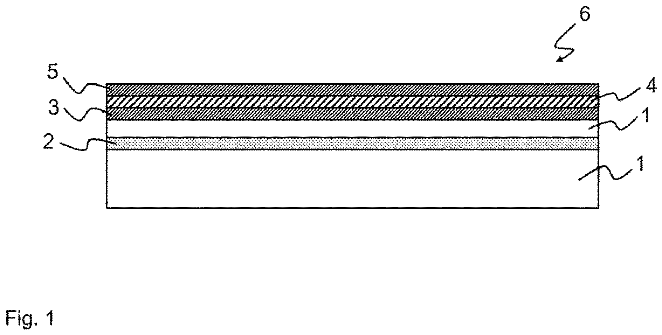

**Fig. 1** displays a sectional view of a substrate wafer according to the invention.

### List of reference numerals employed

1 silicon single crystal wafer
2 gettering region
3 bottom region
4 intermediate region
5 top region
6 substrate wafer

The substrate wafer 6 displayed in Fig. 1 comprises a silicon single crystal wafer 1, a gettering region 2 and an AIN nucleation layer forming the nitrogen enriched passivation layer and consisting of a bottom region 3, a top region 5 and an intermediate region 4. The nitrogen concentration is higher in a top region 5 and the bottom region 3 compared to the nitrogen concentration in the intermediate region 4.

## Claims

1. A method for manufacturing a substrate wafer for building group III-V devices thereon, comprising
providing a silicon single crystal wafer;
forming a gettering region below a top surface of the silicon single crystal wafer; forming a nitrogen enriched passivation layer representing a top portion of the substrate wafer.

2. The method as claimed in claim 1, wherein the nitrogen enriched passivation layer is formed by diffusing nitrogen or implanting nitrogen ions in a top region of the silicon single crystal wafer.

3. The method as claimed in claim 2, wherein the nitrogen enriched passivation layer is formed by subjecting the silicon single crystal wafer to a thermal treatment in an atmosphere containing a nitriding gas.

4. The method as claimed in claim 2, wherein the gettering region is formed as an end-of-range damage when the nitrogen ions are implanted in the top region of the silicon single crystal wafer.

5. The method as claimed in claim 1, wherein the gettering region is formed by implanting hydrogen ions into the silicon single crystal wafer and annealing the silicon single crystal wafer to form a layer of buried voids below the top surface of the silicon single crystal wafer.

6. The method as claimed in claim 1, wherein the nitrogen enriched passivation layer is formed by depositing an AIN nucleation layer contacting the top surface of the silicon single crystal wafer, the nitrogen concentration in the AIN nucleation layer being higher in a top region and a bottom region of the AIN nucleation layer compared to an intermediate region between the top region and the bottom region.

7. The method as claimed in claim 5, comprising
temporarily increasing the partial pressure of a nitrogen containing precursor gas during the deposition of the AIN nucleation layer.

8. A substrate wafer for building group III-V devices, comprising
a silicon single crystal wafer;
a gettering region below the top surface of the silicon single crystal wafer; and
a nitrogen enriched passivation layer.

9. The substrate wafer as claimed in claim 8, wherein the nitrogen enriched passivation layer forms a top portion of the substrate wafer.

10. The substrate wafer as claimed in claim 8, wherein the nitrogen enriched passivation layer is part of an AIN nucleation layer contacting a top surface of the silicon single crystal wafer.

11. The substrate wafer as claimed in claim 10, wherein a concentration of nitrogen in the AIN nucleation layer being higher in a top region and a bottom region of the AIN nucleation layer compared to a region between the top region and the bottom region.

12. The substrate wafer as claimed in any of claims 8 to 11, wherein the gettering region consists of a layer of buried voids.

13. The substrate wafer as claimed in any of claims 8 to 11, wherein the gettering region consists of an end-of-range damage.
